# EUROPÄISCHE PATENTSCHRIFT

(11) **EP 0 905 278 B1**
(45) Veröffentlichungstag und Bekanntmachung des Hinweises auf die Patenterteilung: **15.06.2005**
(21) Anmeldenummer: 98117689.4
(22) Anmeldetag: 17.09.1998
(51) Int. Cl.: C23C 18/12

(54) **Herstellverfahren für eine keramische Schicht**
Method of manufacturing a ceramic coating
Procédé de fabrication d'une couche en céramique

(30) Priorität: 30.09.1997 DE 19743270
(43) Veröffentlichungstag der Anmeldung: 31.03.1999
(73) Patentinhaber: Infineon Technologies AG, 81669 München (DE)
(72) Erfinder: Hintermaier, Frank, Dr., 81373 München (DE); Mazure-Espejo, Carlos, Dr., 85604 Zorneding (DE)
(74) Vertreter: Zimmermann & Partner

(56) Entgegenhaltungen:
- WO-A-90/13149
- FR-A- 2 498 951
- JP-A- 3 295 808
- US-A- 5 244 691
- BOYLE T J ET AL: "Formation of SrBi/sub 2/Ta/sub 2/O/sub 9/. I. Synthesis and characterization of a novel "sol-gel" solution for production of ferroelectric SrBi/sub 2/Ta/sub 2/O/sub 9/ thin films" JOURNAL OF MATERIALS RESEARCH, SEPT. 1996, MATER. RES. SOC, USA, Bd. 11, Nr. 9, ISSN 0884-2914, Seiten 2274-2281, XP002090044

## Beschreibung

Die Erfindung betrifft ein Herstellverfahren für eine keramische Schicht aus mindestens zwei Precursoren auf einem Substrat, insbesondere für eine keramische Schicht mit ferroelektrischen, paraelektrischen oder supraleitenden Eigenschaften, wobei SBT als Material der keramischen Schicht für dieses Verfahren ausgenommen ist. Weiterhin betrifft die vorliegende Erfindung verschiedene Herstellverfahren für eine keramische SBT-Schicht.

In der Halbleitertechnologie findet die Verwendung von keramischen Dünnfilmschichten zunehmend Interesse. In dieser Sudstanzklasse gibt es Verbindungen mit supraleitenden, ferroelektrischen oder dielektrischen Eigenschaften mit hoher Dielektrizitätkonstante. Die beiden letztgenannten Verbindungsklassen bieten insbesondere Vorteile beim Einsatz als Speicherdielektrikum in Kondensatoren einer integrierten Schaltung.

Ein Beispiel für eine Halbleiterschaltung mit einem Kondensator ist eine DRAM-Speicherzelle. Zur Erhöhung der Integrationsdichte kann sie als sogenannte Stacked Capacitor-Zelle realisiert werden, bei der der Speicherkondensator oberhalb des zugehörigen Auswahltransistors angeordnet ist. Einen wesentlichen Einfluß auf den Platzbedarf eines solchen Kondensators hat unter anderem die Wahl des Kondensatordielektrikums.

Konventionelle Kondensatoren benutzen als Speicherdielektrikum meist Siliziumoxid- bzw. -nitridschichten, die eine Dielektrizitätskonstante von maximal 8 besitzen. Die paraelektrischen Materialien der genannten Substanzklasse, wie beispielsweise BST (Barium-Strontium-Titanat, (Ba,Sr)TiO₃) und ähnliche besitzen eine Dielektrizitätskonstante ε > 150 und ermöglichen somit einen kleineren Kondensator bei gleicher Kapazität.

Derartige Speicherelemente mit einem paraelektrischen Material als Kondensatordielektrikum (DRAM) verlieren bei Ausfall der Versorgungsspannung ihre Ladung und somit ihre gespeicherte Information. Weiter müssen konventionelle Speicherelemente wegen des Restleckstroms ständig neu beschrieben werden (Refresh-Time). Der Einsatz eines ferroelektrischen Materials als Speicherdielektrikum erlaubt aufgrund der unterschiedlichen Polarisationsrichtungen den Bau eines nichtflüchtigen Speichers, der seine Information bei Ausfall der Versorgungsspannung nicht verliert und nicht ständig neu beschrieben werden muß. Der Restleckstrom der Zelle beeinflußt nicht das gespeicherte Signal. Beispiele für ein ferroelektrisches Material aus der genannten Substanzklasse sind PZT (Blei-Zirkonium-Titanat, Pb(Zr Ti)O₃) und SBT (Strontium-Bismuth-Tantalat, SrBi₂Ta₂O₉).

Da die Herstellung dieser neuen Ferro- und Paraelektrika im allgemeinen bei hohen Temperaturen in einer oxidierenden Atmosphäre erfolgt, wird insbesondere für die erste Kondensatorelektrode ein Material benötigt, das mit diesen Bedingungen kompatibel ist. Es wird üblicherweise Pt, Ru, RuO₂ oder ein ähnliches Material eingesetzt.

Für die Herstellung von keramischen Dünnfilmen sind drei wesentliche Methoden bekannt: Ein Sputterprozeß, ein CVD-Verfahren und ein sogenannter Sol-Gel-Prozeß. Beim Sol-Gel-Prozeß werden metallorganische Ausgangschemikalien in der Regel in einem unpolaren, aromatischen Lösungsmittel gelöst (beispielsweise in Xylol), die Lösung auf einen Wafer aufgebracht und abgeschleudert (spin-on-Verfahren). Der so erhaltene dünne Film aus metallorganischen Molekülen wird anschließend bei Gegenwart von Sauerstoff in einen Oxydfilm überführt. Bei einer anschließenden Temperung, die im Fall von SBT typischerweise in einem Temperaturbereich von 700 bis 800° C durchgeführt wird, geht dieser Oxydfilm in die Phase mit den gewünschten elektrischen Eigenschaften über. Im Fall einer SBT-Schicht wird die Schichtperovskit-Phase mit ferroelektrischen Eigenschaften gebildet, bei BST oder PZT liegt ein einfacher Perovskit vor (Temperung bei 450 - 650°C). Ein Beispiel für einen derartigen Sol-Gel-Prozeß ist in der internationalen Patentanmeldung WO 93/12538 beschrieben. Bei diesen Herstellverfahren ist die Verwendung der üblichen Lösungsmittel, insbesondere der unpolaren aromatischen Lösungsmittel, aufgrund der Giftigkeit und der potentiellen Krebsgefahr der Dämpfe problematisch.

Die WO 90/13149 offenbart ein Sol-Gel-Verfahren zur Herstellung einer ferroelektrischen, polykristallinen PZT-Schicht (Pb(Zr,Ti)O₃). Bei diesem Verfahren werden die Precursoren (wie Blei Acetate, Zirkonium Propoxyde und Titan Isoproxyde) zuerst in Essigsäure gelöst und anschließend ein Glykol (z.B. OHCH₂CH₂OH) bzw. Glycerol (Glycerin) zugegeben, um die eigentliche Lösung der Precursoren fertigzustellen. Diese Lösung der Precursoren wird anschließend auf ein Substrat aufgebracht und einer Wärmebehandlung unterzogen, um die ferroelektrische, polykristalline PZT-Schicht (Pb(Zr,Ti)O₃) zu erzeugen. Entsprechend der WO 90/13149 wird ein Glykol (z.B. OHCH₂CH₂OH) bzw. Glycerol (Glycerin) als sogenannter "Firing Agent" hinzugefügt. Dieser sogenannte "Firing Agent" hat unter anderem die Aufgabe die Viskosität der Lösung zu steuern und erfüllt damit die Erfordernisse eines zusätzlichen Lösungsmittels.

Ein weiteres Herstellverfahren ist in dem Artikel von Preston und Härtling in "Integrated Ferroelectrics, 1992, Vol. 1, Seiten 89 bis 98" beschrieben. Für die Herstellung von PLZT-Schichten werden als Precursoren die Acetate der entsprechenden Metalle verwendet, als Lösungsmittel wird Wasser eingesetzt. Ein Nachteil dieses Verfahrens ist die hohe Polarität von Wasser, die zu Schwierigkeiten mit der Benetzung des Substrats und dadurch zu Schichtdickeninhomogenität führen kann. Ferner besteht die Gefahr des Abblätterns der Keramikschicht.

Ein Herstellverfahren für SBT ist ferner in dem Artikel T. Boyle et al in Journal of Material Research, Vol. 11, Nr. 9, Sept. 96, Seiten 2274 bis 2281 beschrieben. Dabei werden der Ta-haltige und der Sr-haltige Precursor in Essigsäure gelöst, während der Bi-haltige Precursor in Pyridin gelöst wird. Nachteilig bei diesem Verfahren ist die Verwendung zweier verschiedener Ausgangslösungen, die unmittelbar vor der Waferbeschichtung gemischt werden. Darüber hinaus besteht das Problem der Alterung der die Essigsäure enthaltenden Ausgangslösung. In dieser reagiert der Ta-haltige Precursor mit der Essigsäure unter Bildung von Essigester und Wasser. Das Wasser hydrolisiert den Ta-haltigen Precursor, wodurch hochmolekulare Tantaloxydcluster gebildet werden. Im Laufe der Zeit wird kolloidales und später suspendiertes Ta₂0₅ erzeugt, was an einer Viskositätsänderung nach ca. 1 Woche und einer Trübung nach ca. 2 Wochen erkennbar ist. Daher ist die Aufbewahrung des Ta-haltigen Precursors in Essigsäure auf Dauer nicht möglich.

Aufgabe der vorliegenden Erfindung ist es, ein einfaches Herstellverfahren für eine keramische Schicht auf einem Substrat anzugeben, das lediglich ungiftige Lösungsmittel und einfach aufgebaute Precursoren vewendet.

Diese Aufgabe wird gemäß einem ersten Aspekt der vorliegenden Erfindung durch ein Verfahren mit den Merkmalen des Anspruchs 1 gelöst, sowie in weiteren Aspekten durch die Verfahren gemäß den unabhängigen Patentansprüchen 5, 7 und 12 gelöst.

Die Erfindung beruht darauf, lediglich eine organische Säure CₙH₂ₙ₊₁COOH mit n=0,1,2 (also Ameisensäure, Essigsäure oder Propionsäure) als Lösungsmittel für die Precursoren einzusetzen. Überraschenderweise wurde festgestellt, daß - im Gegensatz zur Aussage in dem Artikel von Boyle et al - in diesen Säuren die gängigen Precursoren, insbesondere auch Bi-haltige Precursoren, löslich sind. Werden die Precursoren zusammengegeben und bspw. Essigsäure zugefügt, wurde eine gute Löslichkeit beobachtet. Dies kann auf kooperative Effekte der einzelnen Precursoren zurückgeführt werden, beispielsweise durch Änderung der Polarität der Essigsäure durch einen Precourser oder durch Wechselwirkungen der Precursoren untereinander. Durch Zugabe von Wasser kann die Löslichkeit noch verbessert werden.

In weiterer Ausgestaltung der Erfindung kann auch das Problem der mangelnden Langzeitstabilität gelöst werden, ohne daß ein anderes Lösungsmittel als die genannten Säuren, ggf mit Wasser, eingesetzt wird. Beim oben erläuterten Beispiel SBT werden der Bi-haltige Precursor und der der Sr-haltige Precursor in bspw. Essigsäure gelöst. Diese Lösung ist stabil. Durch Zugabe von Wasser kann eine weiter erhöhte Langzeitstabilität erreicht werden. Die vorliegende Lösung wird auf eine Temperatur gebracht, die oberhalb des Schmelzpunktes des Ta-haltigen Precursors liegt. Unmittelbar vor der Beschichtung werden die beschriebene Lösung und der flüssige Ta-haltige Precursor gemischt, wobei das gesamte System auf eine Temperatur oberhalb der beschriebenen Schmelztemperatur gebracht werden muß. Die Lösung und der flüssige Ta-haltige Precursor werden direkt innig vermischt, wobei im Fall einer wasserhaltigen Lösung die Vermischung schnell erfolgen muß, um die Konzentration des Ta-haltigen Precursors schnell zu senken und so eine rasche Koagulation des Hydrolyseprodukts zu verhindern. Das erhaltene Gemisch wird im Spin-on-Verfahren auf das Substrat aufgebracht.

Ein wesentlicher Vorteil der vorliegenden Erfindung besteht in der Verwendung der ungiftigen Säuren, insbesondere bei Einsatz von Essigsäure oder Propionsäure. Dadurch ergeben sich geringere Schutzmaßnahmen und eine einfacherere Entsorgung. Ein weiterer Vorteil der Säuren ist, daß sie aufgrund ihrer Polarität nicht nur im Stande sind, die bislang verwendeten metallorganischen Chemikalien zu lösen, sondern darüber auch andere, weniger kompliziert aufgebaute Verbindungen lösen kann. Damit steht ein breites Spektrum an Ausgangschemikalien zur Verfügung. Die bislang verwendeten metallorganischen Chemikalien haben darüberhinaus die Nachteile, daß sie einerseits am Markt nicht immer gut verfügbar sind, andererseits oft nur mit geringem Reinheitsgrad bezogen werden können. Die genannten Vorteile führen außerdem zu einer Kostenreduktion.

Als Precursoren eignen sich in vielen Fällen die Salze der genannten Säuren oder Oxyde der Metalle, ferner können die Metalle auch direkt in der Säure gelöst werden. Als Ta-haltiger Precurser können die Verbindungen Ta(OEt)₄(acac), Ta(OEt)₅ oder Ta(OMe)₅ eingesetzt werden.

Die Erfindung wird im folgenden anhand von Ausführungsbeispielen näher erläutert. In den Figuren sind die Verfahrensabläufe schematisch dargestellt.

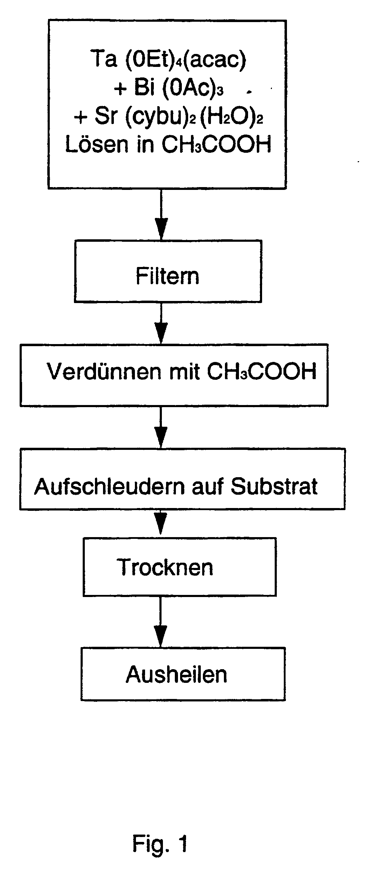

Im ersten Ausführungsbeispiel zur Herstellung von SBT werden folgende Precursoren verwendet:
Ta(OEt)₄(acac) als Ta-Precursor, Bi(OAc)₃ als Bi-Precursor und Sr(cybu)₂(H₂O)₂ als Sr-Precursor (OEt = Ethoxid, acac = Acetylacetonat, OAc = Acetat, cybu = Cyclohexylbutyrat). 3,012 g des Ta-Precursors, 2,552 g des Bi-Precursors und 1,451 g des Sr-Precursors werden unter Erwärmen in 13,880 g Essigsäure gelöst. (FIG 1). Nach Abkühlen wird durch ein 0,2 µm Filter filtriert, aus der so erhaltenen Stammlösung können durch Verdünnen mit Essigsäure weitere Lösungen erhalten werden. Die Lösung wird auf das Substrat aufgetragen und bei etwa 2500 Upm 1 min abgeschleudert. Anschließend wird die Schicht getrocknet, indem sie innerhalb von 30 min auf 100° C gebracht wird. Die Pyrolyse findet bei etwa 460° C an Luft, beispielsweise in einem Gebläseofen, statt, die Dauer beträgt typischerweise 8 Stunden. Vorzugsweise wird die Temperatur mit 60° C/h hochgeregelt, um eine Verflüchtigung des Bi-Preoursors zu vermeiden. Je nach Verdünnung der Stammlösung werden verschiedene SBT-Schichtdicken erhalten. Die unverdünnte Stammlösung ergibt auf einem aus Platin bestehenden Substrat eine Schichtdicke von etwa 200 nm. Die Abnahme der erreichten Schichtdicke durch Verdünnung der Stammlösung mit Essigsäure ist in der folgenden Tabelle dargestellt (Substrat = Pt).

| Lösung | Menge an Stammlösung [g] | Menge an zugefügter Essigsäure [g] | Schichtdicke [nm, ±5 nm] |
|---|---|---|---|
| 1 | Stammlösung | - | 200 |
| 2 | 0.582 | 0.014 | 195 |
| 3 | 0.587 | 0.027 | 190 |
| 4 | 0.578 | 0.040 | 185 |
| 5 | 0.582 | 0.050 | 180 |
| 6 | 0.584 | 0.056 | 175 |
| 7 | 0.577 | 0.070 | 170 |
| 8 | 0.583 | 0.082 | 160 |
| 9 | 0.579 | 0.106 | 155 |
| 10 | 0.582 | 0.122 | 150 |
| 11 | 0.575 | 0.132 | 145 |
| 12 | 0.581 | 0.155 | 140 |
| 13 | 0.581 | 0.164 | 135 |
| 14 | 0.587 | 0.184 | 130 |
| 15 | 0.582 | 0.203 | 125 |
| 16 | 0.586 | 0.221 | 120 |
| 17 | 0.578 | 0.245 | 115 |
| 18 | 0.575 | 0.282 | 110 |
| 19 | 0.581 | 0.294 | 105 |
| 20 | 0.580 | 0.333 | 100 |
| 21 | 0.578 | 0.359 | 100 |
| 22 | 0.583 | 0.378 | 95 |
| 23 | 0.585 | 0.416 | 90 |
| 24 | 0.577 | 0.449 | 90 |
| 25 | 0.577 | 0.491 | 85 |
| 26 | 0.582 | 0.536 | 85 |

Wird als Substrat SiO₂ eingesetzt, ergeben sich bei zähflüssigen Lösungen größere Schichtdicken, beispielsweise bei der Stammlösung eine Dicke von 220 nm. Bei dünnflüssigen Lösungen wird kein Schichtdickenzuwachs beobachtet.

Eine größere Schichtdicke kann mit folgender Stammlösung erzielt werden: 2,768 g des Ta-Precursors, 2,345 g des Bi-Precursors, 1,334 g des Sr-Precursors und 10,629 g Essigsäure. Mit dieser Stammlösung wird auf einem Pt-Substrat eine Schichtdicke von 280 nm erzielt. Auch in diesem Fall kann durch Verdünnen der Stammlösung mit Essigsäure die Schichtdicke herabgesetzt werden, beispielsweise wird mit einer Mischung aus 0,7 g Stammlösung mit 0,038 g Essigsäure eine Schichtdicke von 245 nm erzielt.

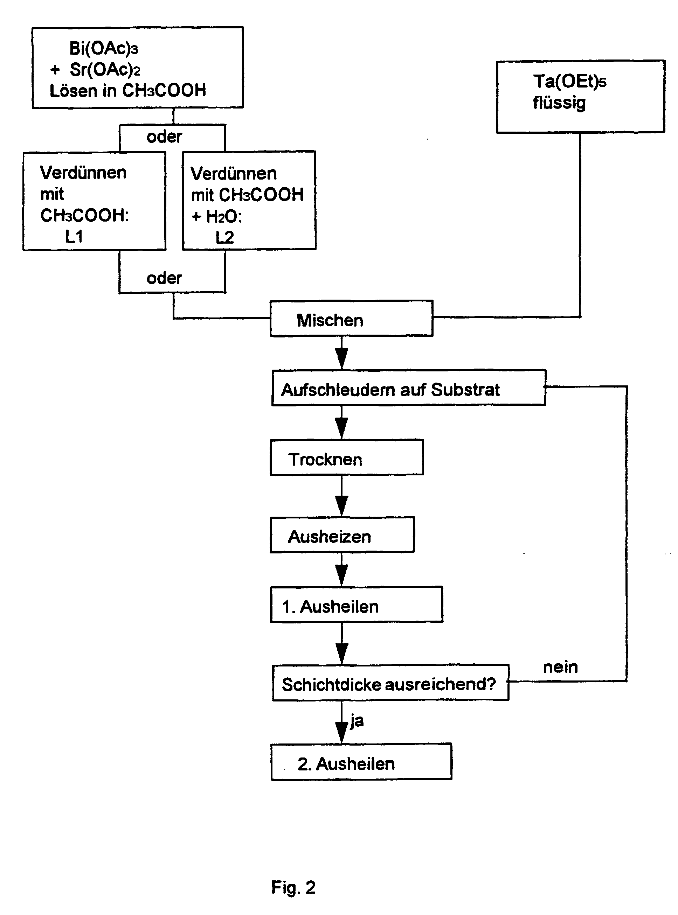

Mit dem beschriebenen Prozeß kann eine SBT-Schicht mit ferroelektrischen Eigenschaften hergestellt werden. Es besteht aber ein Problem in der Alterung der Lösung, nämlich eine Änderung der Viskosität nach etwa 1 Woche und eine Trübung nach etwa 2 Wochen, die wie oben beschrieben auf die Hydrolyse des Ta-haltigen Precursors zurückzuführen ist. Mit der im folgenden beschriebenen zweiten Ausführungsform der Erfindung kann das Problem der Alterung vermieden werden, ohne daß gefährliche Lösungsmittel oder kompliziert aufgebaute Precursoren verwendet werden müssen. Die zweite Ausführungsform wird ebenfalls am Beispiel der Herstellung eines SBT-Films erläutert. Der Verfahrensablauf ist schematisch in FIG 2 dargestellt.

Es werden 2,552 g Bi(OAc)₃ und 1,451 g Sr(OAc)₂, vorzugsweise unter Erwärmen, in 13,880 g Essigsäure gelöst. Nach Auflösen der Precursoren kann mit weiterer Essigsäure verdünnt werden, beispielsweise werden 41,64 g Essigsäure hinzugesetzt. Die so erhaltene Lösung L1 ist stabil. Zur weiteren Erhöhung der Langzeitstabilität kann zu dieser Lösung noch Wasser gegeben werden, beispielsweise wird eine Menge von 2 g Wasser zugegeben (Lösung L2). Als Ta-haltiger Precursor wird vorzugsweise Ta (OEt)₅ verwendet, da dies eine einfache Verbindung mit einem relativ niedrigen Schmelzpunkt (etwa 30° C) ist. Die Lösung und der Ta-Precursor werden getrennt aufbewahrt. Unmittelbar vor der Beschichtung werden sie zusammengemischt, wobei der Ta-haltige Precursor in flüssigem Zustand verwendet wird. Bei dem Mischvorgang wird der Ta-Precursor direkt als Flüssigkeit beispielsweise in einer Düse einer Mischapparatur mit der Lösung L1 oder L2 innig vermischt. Ggf. muß die Mischapparatur so geheizt werden, daß der Ta-Precursor flüssig gehalten wird. Das Gemisch wird aus den oben angegebenen Mengen der Lösung L1 oder L2 und 2,66 g Ta-haltigem Precursor hergestellt. Anschließend wird das Gemisch in einem Spin-on-Verfahren auf das Substrat aufgebracht.

Wird das Gemisch aus der wasserhaltigen Lösung L2 und dem Ta-Precursor hergestellt, ist es wichtig, daß die Vermischung rasch erfolgt, um die Konzentration des Ta-haltigen Precursors schnell zu senken, und so eine Koagulation des Hydrolyseproduktes zu verhindern. Vorzugsweise beträgt die Zeit bis zu einer innigen Vermischung der Komponenten weniger als eine Sekunde.

Nach dem Aufbringen auf das Substrat und Abschleudern wird die Schicht zunächst getrocknet, beispielsweise 5 min lang bei 150° an Luft. Anschließend wird sie etwa 10 min lang auf 290° in normaler Atmosphäre aufgeheizt (Prebake) und dann 10 min lang bei etwa 750° an Luft ausgeheilt (annealing). Es kann auch ein einstufiges Ausheizen eingesetzt werden. Auf diese Weise wird eine etwa 40 nm dicke SBT-Schicht erzielt. Zur Herstellung größerer Schichtdicken kann der beschriebene Verfahrensablauf wiederholt werden. Wenn die gewünschte Schichtdicke erreicht ist, kann anschließend ein letzter Temperschritt durchgeführt werden (bspw. 800° C/1 h/O₂).

Das erfindungsgemäße Verfahren kann auch mit Propionsäure und Propionaten oder Ameisensäure und ihren Salzen anstelle der Essigsäure und den Acetaten durchgeführt werden. Zur Herstellung einer SBT-Schicht werden dann Bi-Propionat und Sr-Propionat und als Lösungsmittel Propionsäure (C₂H₅COOH) eingesetzt.

Mit dem erfindungsgemäßen Verfahren gemäß dem ersten Aspekt der Erfindung können ferner andere keramische Schichten erzeugt werden. Als Lösungsmittel für die Precursoren dient vorzugsweise Essigsäure oder Propionsäure, jeweils ggf. verdünnt mit Wasser. Die geeigneten Precursoren können durch einfache Versuche ermittelt werden, insbesondere kommen die Substanzklassen der Acetate oder Propionate, Ethoxyde, Acetylacetonate, einfache organische Salze der benötigten Metalle, ihre Oxyde oder die Metalle selber (bspw. Auflösen von Sr-Metall in Essigsäure) in Betracht. Wesentliche Kriterien für die Auswahl sind die dem Fachmann bekannten Eigenschaften der jeweiligen Verbindung, die Erhältlichkeit am Markt, die herstellbare Reinheit sowie die Ungefährlichkeit. Die Mengenverhältnisse der Precursoren und der Lösungsmittel in Abhängigkeit der zu erzielenden Dicke und Struktur der Schicht sind ebenfalls durch einfache Versuche bestimmbar.

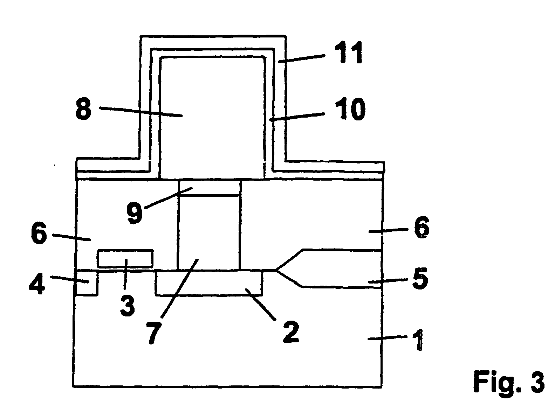

Das Verfahren kann insbesondere bei der Herstellung eines Kondensators in einer integrierten Schaltung, bspw. in einem DRAM- oder FRAM-Speicher eingesetzt werden. Ein Beispiel für einen solchen Speicher ist in Fig. 3 dargestellt. In einem Si-Halbleitersubstrat 1 ist ein MOS-Transistor mit dotierten Gebieten 2, und einem Gate 3 hergestellt, der durch ein Isolationsgebiet 5 von dem Transistor einer benachbarten Speicherzelle getrennt ist. Die Anordung ist mit einer Isolationsschicht 6 abgedeckt. Über eine Anschlußstruktur 7, bspw. aus W oder PolySi, ist das dotierte Gebiet 2 durch die Isolationsschicht 6 hindurch mit einer ersten Elektrode 8 eines Speicherkondensators verbunden. Unter oder auf der ersten Elektrode kann mit einer Barriereschicht 9 zur Verhinderung von 0₂-Diffusion (bspw. TiN) angeordnet sein. Die soweit hergestellte Struktur bildet dann das Substrat, auf das die keramische Schicht 10, insbesondere eine paraelektrische BSTI-Schicht oder eine ferroelektrische SBT-Schicht, als Speicherdielektrikum mit dem erfindungsgemäßen Verfahren aufgebracht wird. Die Speicherzelle wird vervollständigt durch die zweite Elektrode 11.

## Patentansprüche

1. Herstellverfahren für eine keramische Schicht aus mindestens zwei Precursoren auf einem Substrat, wobei SBT (Strontium-Bismuth-Tantalat) als Material der keramischen Schicht ausgenommen ist,
- bei dem als Lösungsmittel für die Precursoren lediglich eine organische Säure CₙH₂ₙ₊₁COOH mit n = 0, 1 oder 2 sowie ggf. Wasser verwendet wird,
- bei dem dann die gelösten Precursoren auf das Substrat aufgebracht werden,
- bei dem dann durch Erwärmen die Schicht hergestellt wird.

2. Herstellverfahren nach Anspruch 1, bei dem alle Precursoren gleichzeitig in der organischen Säure gelöst werden.

3. Herstellverfahren nach Anspruch 1, bei dem ein Teil der Precursoren in der organischen Säure gelöst werden und mindestens ein weiterer Precursor in flüssigem Zustand dieser Lösung hinzugefügt wird.

4. Verfahren nach einem der Ansprüche 1 bis 3, bei dem als Precursor ein Salz der organischen Säure, Oxyd, Ethoxyd oder Methoxid verwendet wird.

5. Herstellverfahren für eine keramische SBT-Schicht (Strontium-Bismuth-Tantalat) aus einem Sr-haltigen Precursor, einem Bi-haltigen Precursor und einem Ta-haltigen Precursor,
- bei dem als Lösungsmittel für die Precursoren lediglich eine organische Säure CₙH₂ₙ₊₁COOH mit n = 1 oder 2 sowie ggf. Wasser verwendet wird,
- bei dem dann die gelösten Precursoren auf das Substrat aufgebracht werden,
- bei dem dann durch Erwärmen die Schicht hergestellt wird, wobei der Sr-haltige Precursor Sr(Cybu)₂(H₂O)₂ ist, der Bi-haltige Precursor Bi(OAc)₃, der Ta-haltige Precursor Ta(OEt)₄(acac) und das Lösungsmittel Essigsäure ist.

6. Herstellverfahren nach Anspruch 5, bei dem alle Precursoren gleichzeitig in der organischen Säure gelöst werden.

7. Herstellverfahren für eine keramische SBT-Schicht (Strontium-Bismuth-Tantalat)aus einem Sr-haltigen Precursor, einem Bi-haltigen Precursor und einem Ta-haltigen Precursor, der Ta(OEt)₄(acac), Ta(OEt)₅ oder Ta(OMe)₅ sein kann, auf einem Substrat,
- bei dem als Lösungsmittel für die Precursoren lediglich eine organische Säure CₙH₂ₙ₊₁COOH mit n = 1 oder 2 sowie ggf. Wasser verwendet wird,
- bei dem dann die gelösten Precursoren auf das Substrat aufgebracht werden,
- bei dem dann durch Erwärmen die Schicht hergestellt wird,
wobei
der Sr-haltige Precursor Sr(OAc)₂ ist, der Bi-haltige Precursor Bi(OAc)₃ und das Lösungsmittel Essigsäure ist.

8. Herstellverfahren nach Anspruch 7, bei dem der Ta-haltige Precursor Ta(OEt)₅ und das Lösungsmittel Essigsäure ist.

9. Herstellverfahren nach Anspruch 7 oder 8, bei dem der Sr-haltige und der Bi-haltige Precursor in der organischen Säure gelöst werden und der Ta-haltige Precursor in flüssigem Zustand dieser Lösung hinzugefügt wird.

10. Verfahren nach einem der Ansprüche 7 bis 9, bei dem der Bi-haltige Precursor und der Sr-haltige Precursor in Essigsäure gelöst werden und auf eine Temperatur gebracht werden, die oberhalb des Schmelzpunktes des Ta-haltigen Precursors liegt, und bei dem der Ta-haltige Precursor in flüssigem Zustand mit dieser Lösung gemischt wird und dieses Gemisch auf das Substrat aufgebracht wird.

11. Herstellverfahren nach Anspruch 10, bei dem der Mischvorgang zwischen Sr-haltigem/Bi-haltigem Precursor und Ta-haltigem Precursor in einem Zeitraum von maximal 1 sec erfolgt.

12. Herstellverfahren für eine keramische SBT-Schicht (Strontium-Bismuth-Tantalat) aus einem Sr-haltigen Precursor, einem Bi-haltigen Precursor und einem Ta-haltigen Precursor, der Ta(OEt)₄(acac), Ta(OEt)₅ oder Ta(OMe)₅ sein kann, auf einem Substrat,
- bei dem als Lösungsmittel für die Precursoren lediglich eine organische Säure CₙH₂ₙ₊₁COOH mit n = 1 oder 2 sowie ggf. Wasser verwendet wird,
- bei dem dann die gelösten Precursoren auf das Substrat aufgebracht werden,
- bei dem dann durch Erwärmen die Schicht hergestellt wird,
wobei
der Sr-haltige Precursor Strontiumpropionat ist, der Bi-haltige Precursor Bismuthpropionat und das Lösungsmittel Propionsäure ist.

13. Herstellverfahren nach Anspruch 12, bei dem der Sr-haltige und der Bi-haltige Precursor in der organischen Säure gelöst werden und der Ta-haltige Precourser in flüssigem Zustand dieser Lösung hinzugefügt wird.

## Claims

1. Process for producing a ceramic layer from at least two precursors on a substrate, in which the material of the ceramic layer is not SBT (strontium bismuth tantalate),
- in which all that is used as solvent for the precursors is one organic acid CₙH₂ₙ₊₁COOH where n = 0, 1 or 2 and if appropriate water,
- in which the dissolved precursors are then applied to the substrate,
- in which the layer is then produced by heating.

2. Production process according to Claim 1, in which all the precursors are dissolved in the organic acid simultaneously.

3. Production process according to Claim 1, in which some of the precursors are dissolved in the organic acid and at least one further precursor is added to this solution in the liquid state.

4. Process according to one of Claims 1 to 3, in which a salt of the organic acid, oxide, ethoxide or methoxide is used as precursor.

5. Process for producing a ceramic SBT (strontium bismuth tantalate) layer from an Sr-containing precursor, a Bi-containing precursor and a Ta-containing precursor,
- in which all that is used as solvent for the precursors is one organic acid CₙH₂ₙ₊₁COOH where n = 1 or 2 and if appropriate water,
- in which the dissolved precursors are then applied to the substrate,
- in which the layer is then produced by heating,
and in which process
the Sr-containing precursor is Sr(Cybu)₂(H₂O)₂, the Bi-containing precursor is Bi(OAc)₃, the Ta-containing precursor is Ta(OEt)₄(acac) and the solvent is acetic acid.

6. Production process according to Claim 5, in which all the precursors are dissolved in the organic acid simultaneously.

7. Process for producing a ceramic SBT (strontium bismuth tantalate) layer from an Sr-containing precursor, a Bi-containing precursor and a Ta-containing precursor, which may be Ta(OEt)₄(acac), Ta(OEt)₅ or Ta(OMe)₅, on a substrate,
- in which all that is used as solvent for the precursors is one organic acid CₙH₂ₙ₊₁COOH where n = 1 or 2 and if appropriate water,
- in which the dissolved precursors are then applied to the substrate,
- in which the layer is then produced by heating,
in which production process
the Sr-containing precursor is Sr(OAc)₂, the Bi-containing precursor is Bi(OAc)₃ and the solvent is acetic acid.

8. Production process according to Claim 7, in which the Ta-containing precursor is Ta(OEt)₅ and the solvent is acetic acid.

9. Production process according to Claim 7 or 8, in which the Sr-containing precursor and the Bi-containing precursor are dissolved in the organic acid and the Ta-containing precursor is added to this solution in the liquid state.

10. Process according to one of Claims 7 to 9, in which the Bi-containing precursor and the Sr-containing precursor are dissolved in acetic acid and heated to a temperature above the melting point of the Ta-containing precursor, and
in which the Ta-containing precursor is mixed with this solution in the liquid state and then this mixture is applied to the substrate.

11. Production process according to Claim 10, in which the operation of mixing the Sr-containing/Bi-containing precursor and the Ta-containing precursor takes at most 1 sec.

12. Process for producing a ceramic SBT (strontium bismuth tantalate) layer from an Sr-containing precursor, a Bi-containing precursor and a Ta-containing precursor, which may be Ta(OEt)₄(acac), Ta(OEt)₅ or Ta(OMe)₅, on a substrate,
- in which all that is used as solvent for the precursors is one organic acid CₙH₂ₙ₊₁COOH where n = 1 or 2 and if appropriate water,
- in which the dissolved precursors are then applied to the substrate,
- in which the layer is then produced by heating,
in which production process
the Sr-containing precursor is strontium propionate, the Bi-containing precursor is bismuth propionate and the solvent is propionic acid.

13. Production process according to Claim 12, in which the Sr-containing precursor and the Bi-containing precursor are dissolved in the organic acid and the Ta-containing precursor is added to this solution in the liquid state.

## Revendications

1. Procédé de production d'une couche en céramique à partir d'au moins deux précurseurs sur un substrat, du SBT (tantalate de strontium et de bismuth) étant exclu en tant que matériau de la couche en céramique,
- dans lequel on utilise comme solvant pour les précurseurs seulement un acide organique CₙH₂ₙ₊₁COOH avec n =0, 1 ou 2, ainsi qu'éventuellement de l'eau,
- dans lequel on dépose ensuite les précurseurs dissous sur le substrat,
- dans lequel on produit ensuite la couche par chauffage.

2. Procédé de production suivant la revendication 1, dans lequel on dissout tous les précurseurs en même temps dans l'acide organique.

3. Procédé de production suivant la revendication 1, dans lequel on dissout une partie des précurseurs dans l'acide organique et on ajoute au moins un autre précurseur à l'état liquide à cette solution.

4. Procédé suivant l'une des revendications 1 à 3, dans lequel on utilise comme précurseur un sel de l'acide organique, un oxyde, un éthylate ou un méthylate.

5. Procédé de production d'une couche SBT en céramique (tantalate de strontium - bismuth) à partir d'un précurseur contenant du Sr, d'un précurseur contenant du Bi et d'un précurseur contenant du Ta,
- dans lequel on utilise comme solvant pour le précurseur seulement un acide organique CₙH₂ₙ₊₁COOH avec n =0, 1 ou 2, ainsi qu'éventuellement de l'eau,
- dans lequel on dépose ensuite les précurseurs dissous sur le substrat,
- dans lequel on produit ensuite la couche par chauffage,
dans lequel
le précurseur contenant du Sr est Sr(Cybu)₂(H₂O)₂, le précurseur contenant du Bi est Bi(OAc)₃, le précurseur contenant du Ta est Ta(OEt)₄(acac) et le solvant est l'acide acétique.

6. Procédé de production suivant la revendication 5, dans lequel on dissout tous les précurseurs en même temps dans l'acide organique.

7. Procédé de production d'une couche SBT en céramique (tantalate de strontium et de bismuth) à partir d'un précurseur contenant du Sr, d'un précurseur contenant du Bi et d'un précurseur contenant du Ta, qui peut être Ta(OEt)₄(acac), Ta(OEt)₅ ou Ta(OMe)₅, sur un substrat,
- dans lequel on utilise comme solvant pour les précurseurs seulement un acide organique CₙH₂ₙ₊₁COOH avec n =0, 1 ou 2, ainsi qu'éventuellement de l'eau,
- dans lequel on dépose ensuite les précurseurs dissous sur le substrat,
- dans lequel on produit ensuite la couche par chauffage,
dans lequel
le précurseur contenant du Sr est Sr(OAc)₂, le précurseur contenant du Bi est Bi(OAc)₃ et le solvant est l'acide acétique.

8. Procédé de production suivant la revendication 7, dans lequel le précurseur contenant du Ta est Ta(OEt)₅ et le solvant est l'acide acétique.

9. Procédé de production suivant la revendication 7 ou 8, dans lequel le précurseur contenant du Sr et le précurseur contenant du Bi sont dissous dans l'acide organique et le précurseur contenant du Ta est ajouté à l'état liquide à cette solution.

10. Procédé suivant l'une des revendications 7 à 9, dans lequel le précurseur contenant du Bi et le précurseur contenant du Sr sont dissous dans de l'acide acétique et sont portés à une température qui est supérieure au point de fusion du précurseur contenant du Ta, et
dans lequel le précurseur contenant du Ta est mélangé à l'état liquide à cette solution et ce mélange est déposé sur le substrat.

11. Procédé de production suivant la revendication 10, dans lequel on effectue l'opération de mélange entre le précurseur contenant du Sr/contenant du Bi et le précurseur contenant du Ta en un laps de temps de 1 seconde au maximum.

12. Procédé de production d'une couche SBT en céramique (tantalate de strontium et de bismuth) à partir d'un précurseur contenant du Sr, d'un précurseur contenant du Bi et d'un précurseur contenant du Ta, qui peut être Ta(OEt)₄(acac), Ta(OEt)₅ ou Ta(OMe)₅, sur un substrat,
- dans lequel on utilise comme solvant pour les précurseurs seulement un acide organique CₙH₂ₙ₊₁COOH avec n =0, 1 ou 2, ainsi qu'éventuellement de l'eau,
- dans lequel on dépose ensuite les précurseurs dissous sur le substrat,
- dans lequel on produit ensuite la couche par chauffage,
dans lequel
le précurseur contenant du Sr est du propionate de strontium, le précurseur contenant du Bi est du propionate de bismuth et le solvant est l'acide propionique.

13. Procédé de production suivant la revendication 12, dans lequel on dissout le précurseur contenant du Sr et le précurseur contenant du Bi dans l'acide organique et l'on ajoute le précurseur contenant du Ta à l'état liquide à cette solution.
